Europäisches Patentamt

European Patent Office

Office européen des brevets

(19)

(11) **EP 1 249 864 A1**

(12) # EUROPÄISCHE PATENTANMELDUNG

(43) Veröffentlichungstag:
**16.10.2002 Patentblatt 2002/42**

(51) Int Cl.[7]: **H01L 21/66**, B28D 5/02

(21) Anmeldenummer: **01810351.5**

(22) Anmeldetag: **09.04.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **ABB Schweiz AG**
**5400 Baden (CH)**

(72) Erfinder:
• **Linder, Stefan**
**4800 Zofingen (CH)**
• **Mukhitdinov, Aziz**
**5600 Lenzburg (CH)**

(74) Vertreter: **ABB Patent Attorneys**
**c/o ABB Schweiz AG**
**Brown Boveri Strasse 6**
**5400 Baden (CH)**

(54) **Verfahren und Gerät zum Reduzieren der Dicke von dünnen Scheiben**

(57)    In dem Verfahren, in dem die Dicke der Scheibe (1) durch Abtragen von Material reduziert wird, wird vor dem Abtragen von Material von der Scheibe die Dicke ($d_1$) der Scheibe bestimmt. Aufgrund der bestimmten Dicke der Scheibe wird festgestellt, wieviel Material von der Scheibe in einem folgenden Verfahrenschritt abgetragen werden soll. Zum Bestimmen der Dicke ($d_1$) der Scheibe wird das Gewicht der Scheibe mit einer Wägeeinheit (4) festgestellt, und aufgrund des festgestellten Gewichts die Dicke der Scheibe berechnet.

Dank sehr hoher Sensitivität modernster Wägeeinheiten ist die über das Gewicht bestimmte Dicke der Scheibe erheblich genauer als die direkte mechanische Dickemessung.

Fig.1

EP 1 249 864 A1

## Beschreibung

Technisches Gebiet

Die vorliegende Erfindung bezieht sich auf das Gebiet der Herstellung von dünnen Scheiben, insbesondere Halbleiterscheiben (sogenannte "Halbleiterwafer").

Sie betrifft ein Dickereduzierverfahren zum Reduzieren der Dicke von dünnen Scheiben, insbesondere Halbleiterscheiben, gemäss dem Oberbegriff des Patentanspruchs 1.

Sie betrifft weiter ein Gerät zum Reduzieren der Dicke von dünnen Scheiben, insbesondere von Halbleiterscheiben, gemäss dem Oberbegriff des Patentanspruchs 11.

Stand der Technik

Leistungshalbleiter sind im Betriebszustand mit Verlusten beaufschlagt. Diese Verluste, insbesondere Durchlass- und Schaltverluste, skalieren überproportional stark mit der Dicke des Halbleiterbauelements (auch Halbleiterchip genannt). Je dünner das Halbleiterbauelement ist, desto geringer sind diese Verluste.

Bei der Herstellung werden eines oder mehrere Halbleiterbauelemente aus einer Halbleiterscheibe (Halbleiterwafer) gefertigt.

Um die Verluste zu minimieren unternehmen Herstellerfirmen von Leistungshalbleitern grösste Anstrengungen, die physikalischen Grenzen auszureizen indem sie die Dicke der Halbleiterscheiben auf ein Mimimum zu reduzieren versuchen.

Dabei treten im Wesentlichen zwei Probleme auf:

1. die angestrebte Dicke, die sogenannte Zieldicke, muss umso genauer eingehalten werden, je mehr sie sich der physikalischen Grenze nähert. Ein typischer Wert für die geforderte Standardabweichung liegt im Bereich von einem Mikrometer oder weniger.

2. Speziell für Leistungshalbleiter mit Sperrspannungen im Bereich von ca. 300 V bis 2500 V, stellt sich das Problem, dass die Zieldicke der Halbleiterscheiben so gering ist, dass grosse Bruchgefahr bei der Herstellung der Halbleiterscheiben herrscht.

Um die für Leistungshalbleiter mit hohen Sperrspannungen geforderten, dünnen Zieldicken zu erreichen, wird herkömmlich beispielsweise ein Verfahren mit den folgenden Verfahrensschritten angewendet:

1. Die Halbleiterscheibe wird zur Bearbeitung auf eine Trägerfolie, beispielsweise ein sogenanntes "Blue Tape", aufgezogen.

2. Die ursprüngliche Dicke der Halbleiterscheibe wird mittels Schleifen auf eine erste Dicke, die sogenannte Ausgangsdicke, reduziert. Die Ausgangsdicke ist maximal so dünn bemessen, dass die Halbleiterscheibe beim Schleifen oder bei den nachfolgenden Bearbeitungsschritten gerade noch nicht zu brechen droht. Bei einer runden Halbleiterscheibe mit einem Durchmesser von 125 mm beispielsweise, beträgt die Ausgangsdicke ca. 150 - 200 Mikrometer. Die Halbleiterscheibe wird dabei während dem Schleifen von der Folie gestützt, und insbesondere gegen Brechen geschützt.

3. Die Folie wird von der Halbleiterscheibe abgezogen.

4. Die Ausgangsdicke wird gemessen, und als ein Abtragparameter in den nächsten Verfahrensschritt einbezogen. Ebenfalls als Abtragparameter können gemessene Dicken von vorhergehend bearbeiteten Halbleiterscheiben miteinbezogen werden.

5. Ausgehend von der Ausgangsdicke und unter Berücksichtigung der errechneten Abtragparametern wird die Dicke der Halbleiterscheibe mittels chemischem Rückätzen auf die gewünschte Zieldicke reduziert.

6. Die erreichte Zieldicke wird gemessen. Um die angestrebten Zieldicken für eine ganze Serie von Halbleiterscheiben möglichst genau zu erreichen, kann die gemessene Zieldicke wiederum als Abtragparameter für später zu bearbeitende Halbleiterscheiben berücksichtigt werden.

Da die Zieldicke in der Regel im Vergleich zur Ausgangsdicke wesentlich geringer ist, muss im Schritt 4 dieses beispielhaften Verfahrens eine erhebliche Menge von Halbleitermaterial abgetragen werden. Da die Variation der Ätzung und die Prozesskosten kontinuierlich mit der abzutragenden Menge Material zunehmen, erweist sich diese Verfahrensvariante als sehr kostspielig.

Um diese Kosten zu reduzieren, könnte theoretisch die Folie gemäss Schritt 3 des beispielhaften Verfahrens erst nach der Ätzung entfernt werden. Die grösste Bruchgefahr geht von mechanischen Schäden an der Halbleiterscheibe aus, wobei die beim Schleifen entstehenden Schäden durch die chemische Ätzung wieder entfernt werden. Durch die erwähnte, durch die stützende Folie gegebene Stabilität kann die Halbleiterscheibe auf eine Ausgangsdicke vorgeschliffen werden, welche der wesentlich näher bei der Zieldicke liegt. Die Bruchgefahr, insbesondere beim Abziehen der Folie von der Halbleiterscheibe, könnte auf diese Weise reduziert werden. Dieser Prozessablauf birgt jedoch das neue Problem, dass sich die mitunter recht starke Variation der Foliendicke im Bereich von einigen Mikrometern direkt auf die gemessenen Dicken der Halbleiterscheibe auswirkt, da zumindest für die Messung der Ausgangsdicke die Halbleiterscheibe auf der Folie aufliegt. Die erzielten Kostenvorteile dieser Verfahrensvariante bringen somit zu Lasten der Genauigkeit, was sicher nicht erstrebenswert ist.

Zwei weitere Probleme des oben erwähnten, beispielhaften Verfahrens ergeben sich bei der Dickemessung vor und nach der Ätzung:

1. Falls die eine Grundseite des Wafers bereits Halbleiterstrukturen aufweist, welche gewisse topographische Unebenheiten aufweisen, hängt das Messresultat stark von der exakten Lage des Messpunktes ab. Speziell bei kleinen Chips können somit bereits geringe Abweichungen vom Zielpunkt grosse Messfehler verursachen. Um eine genauere Messung zu erhalten müssten allenfalls mehrere Messungen an verschiedenen Stellen der Halbleiterscheibe durchgeführt werden, was den Prozessablauf möglicherweise verlangsamt und/oder verteuert.

2. Da eine genaue Dickenmessung üblicherweise durch Abtasten der Halbleiterscheibe mittels mechanischem Tastfühler erfolgt, kann die Halbleiterscheibe bei der Messung verschmutzt oder mechanisch beeinträchtigt (z.B. verkratzt) werden. Im schlimmsten Fall kann sie sogar brechen. Diese letztgenannte Gefahr besteht insbesondere bei der wichtigen Messung der Ausgangsdicke vor der Ätzung, solange die Halbleiterscheibe mit gewissen mechanischen Schäden behaftet ist.

Kurze Darstellung der Erfindung

Die Aufgabe der vorliegenden Erfindung besteht demzufolge darin, ein Verfahren sowie ein Gerät zum Reduzieren der Dicke von dünnen Scheiben, insbesondere von Halbleiterscheiben, gemäss den Oberbegriffen der unabhängigen Patentansprüchen zu schaffen, mit denen die Dicke von dünnen Scheiben, insbesondere von Halbleiterscheiben, kostengünstig mit grosser Genauigkeit auf eine bestimmte Zieldicke reduziert werden können.

Die Aufgabe wird durch die Merkmale der unabhängigen Ansprüche 1 und 11 gelöst.

Der Kern der Erfindung liegt dabei darin, dass in dem Verfahren, in dem die Dicke der Scheibe durch Abtragen von Material reduziert wird, wobei vor und/oder nach dem Abtragen von Material der Scheibe die Dicke der Scheibe bestimmt wird, um aufgrund der bestimmten Dicke der Scheibe festzustellen, wieviel Material von der Scheibe in einem folgenden Verfahrenschritt abgetragen werden soll, und/ oder wieviel Material von einem oder mehreren weiteren, dickemässig zu reduzierenden Scheiben abgetragen werden soll, zum Bestimmen der Dicke der Scheibe das Gewicht der Scheibe festgestellt wird, und dass aufgrund des festgestellten Gewichts die Dicke der Scheibe berechnet wird.

Durch die erfindungsgemässe Bestimmung der Dicke der Scheibe durch Feststellen des Gewichts der Scheibe ergibt sich in aus einer Messung eine mittlere Dicke der Scheibe, welche insbesondere unabhängig von allfälligen topographischen Unebenheiten der Scheibe ist.

Dank sehr hoher Sensitivität modernster Wägeeinheiten ist die über das Gewicht bestimmte Dicke der Scheibe erheblich genauer als die direkte mechanische Dickemessung.

In einer bevorzugten Ausführungsform des erfindungsgemässen Verfahrens trägt eine Trägerfolie die Scheibe auch während dem Bestimmen der Dickeder Scheibe, ohne dass die Bestimmung der Dicke dabei wesentlich beeinflusst wird. Da die Folie in der Regel im Vergleich zum Material der Scheibe ein wesentlich geringeres spezifisches Gewicht aufweist, können allfällige Unterschiede in der Foliendicke für eine genügend genaue Bestimmung der Dicke der Scheibe annähernd vernachlässigt werden.

Mit dem erfindungsgemässen Verfahren ergibt sich somit die Möglichkeit, während allen Materialabtragungen mit vor- und/ oder nachheriger Bestimmung der Dicke der Scheibe die Scheibe auf der Trägerfolie aufgezogen zu belassen, ohne wesentliche Einschränkungen bezüglich der Genauigkeit in kauf nehmen zu müssen. Auf diese Weise kann die Gefahr eines Bruchs der Scheibe minimiert werden, selbst wenn bereits bei einer ersten, mechanischen Abtragung eine sehr geringe Dikke angestrebt wird, um bei einer anschliessenden, chemischen Abtragung nur noch wenig Material abtragen zu müssen.

Die Folie beschützt zudem bei einer chemischen Abtragung (Ätzung) die abgewandte Scheibengrundfläche bestmöglich vor allfälligen mechanischen Schäden, beispielsweise durch Berührung mit Transporteinrichtungen, und vor Verschmutzung, beispielsweise durch die Auflagefläche der Wägeeinheit.

Ein weiterer Vorteil des erfindungsgemässen Verfahrens besteht darin, dass die Sensitivität der Bestimmung der Dicke der Scheibe mit abnehmender Dikke zunimmt, da die relative Änderung des Gewichts der Scheibe für eine Abtragung grösser wird, je dünner die Scheibe ist.

Da bei dem erfindungsgemässen Verfahren die Scheibe zur Bestimmung der Dicke lediglich auf eine Wägeeinheit gelegt werden müssen, und die aufwendige Abtastung durch mechanische Tastsensoren entfällt, ergeben sich weitere Vorteile im Herstellungsprozess der Scheiben, insbesondere bezüglich verbesserter Automatisierung.

Das erfindungsgemässe Gerät zum Reduzieren der Dicke von dünnen Scheiben, insbesondere von Halbleiterscheiben, zeichnet sich durch einen einfachen Aufbau mit im Wesentlichen zwei Einheiten aus. Einer Materialabtrageeinheit sowie einer Wägeeinheit.

In einer besonders vorteilhaften Ausführungsform des erfindungsgemässen Geräts, sind die Materialabteilungseinheit und die Wägeeinheit derart zu einer einzigen Einheit zusammengeführt, dass eine zu bearbeitende Scheibe zwischen der Materialabtragung und dem Wägen nicht bewegt werden muss. Dadurch ergeben sich erhebliche Vorteile bezüglich verbesserter Automatisierung des Herstellungsprozesses.

Kurze Beschreibung der Zeichnungen

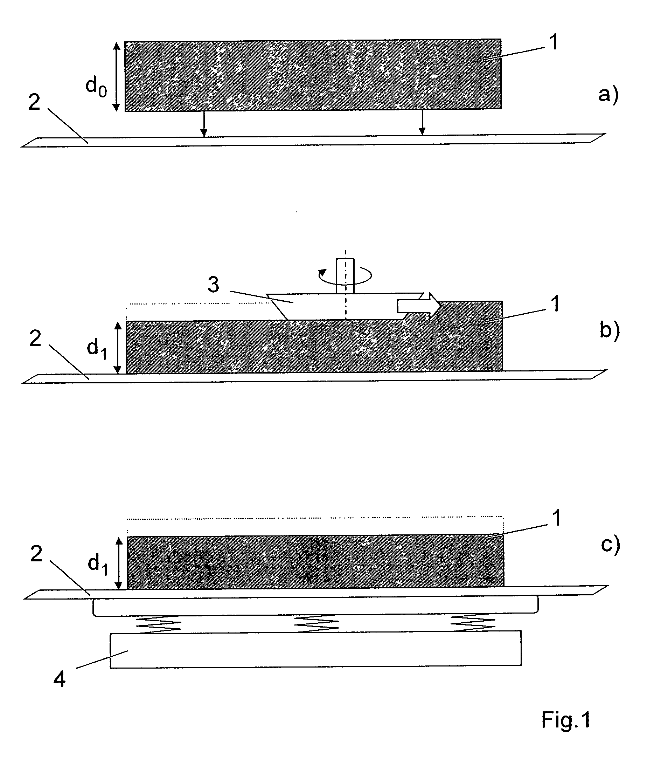

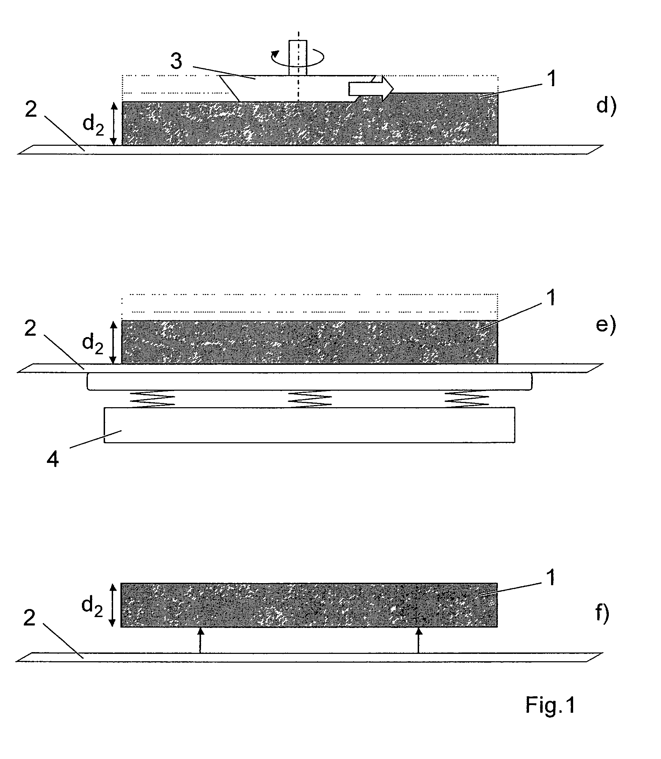

Fig. 1 a) bis f) zeigt schematisch der Reihe nach wesentliche Schritte des erfindungsgemässen Verfahrens.

Weg zur Ausführung der Erfindung

Die wesentlichen Verfahrensschritte der erfindungsgemässen Verfahrens zum Reduzieren der Dicke von dünnen Scheiben, insbesondere Halbleiterscheiben lassen sich anhand der Fig.1 a) bis f) erläutern. Die Darstellungen sind skizzenhaft und bezüglich der Längenverhältnissen nicht massstabsgetreu.

Fig. 1 a) zeigt, wie eine dünne Scheibe 1, welche beispielsweise eine Halbleiterscheibe aus Silizium ist, mit einer Trägerfolie 2, oder einem anderen, geeigneten Trägersubstrat, verbunden wird. Die Halbleiterscheibe 1 haftet dabei an der Folie 2, beispielsweise durch eine Klebstoffbeschichtung auf der Folie. Die Halbleiterscheibe 1 liegt mit einer Grundfläche auf der Folie auf und hat eine ursprüngliche Dicke $d_0$. Die Halbleiterscheibe weist eine bestimmte Grundfläche A auf. Das Material der Halbleiterscheibe ist bekannt, insbesondere das spezifische Gewicht bzw. die Dichte p. Eine typische Halbleiterscheibe hat eine annähernd kreisrunde Grundfläche mit einem Durchmesserzwischen 50 mm und 300 mm. Die ursprüngliche Dicke $d_0$ einer solchen Halbleiterscheibe beträgt typischerweise einige hundert Mikrometer, beispielsweise 200 - 1000 Mikrometer.

Fig. 1 b) zeigt den nächsten Verfahrensschritt, bei dem die Halbleiterscheibe mittels einem Schleif- oder Läppgerät 3 auf die Ausgangsdicke $d_1$ gedünnt wird. Dieser erste Materialabtragevorgang wird von einer Steuereinheit anhand von Abtrageparametern gesteuert. Die Halbleiterscheibe wird dabei von der Folie gestützt, um bei abnehmender Dicke nicht beschädigt zu werden.

Fig. 1 c) zeigt den nächsten Verfahrensschritt, bei dem die Halbleiterscheibe 1 zusammen mit der Folie 2 auf einer Wägeeinheit 4 aufliegt und das Gewicht $G_1$ der auf die Ausgangsdicke $d_1$ reduzierten Halbleiterscheibe festgestellt wird. Anhand des festgestellten Gewichts $G_1$ und der bekannten, oben aufgeführten Grössen wird in der Steuereinheit die genaue, mittlere Ausgangsdicke $d_1$ der Halbleiterscheibe berechnet

$$d_1 = \frac{(G_1 - G_T)}{g} \cdot \frac{1}{A \cdot \rho_{Si}}.$$

$G_T$ bezeichnet das (bekannte) Gewicht der Folie 2. Mit der bestimmten Ausgangsdicke $d_1$ werden anschliessend die Abtrageparamter für einen zweiten Materialabtragevorgang bestimmt.

Dieser zweite Materialabtragevorgang ist in Fig. 1 d) dargestellt. Wiederum wird die Halbleiterscheibe 1 von einer Abtrageeinheit 3 dickemässig reduziert. Anstelle der dargestellten, mechanischen Abtrageeinheit kann für diesen Vorgang, ebenso für alle anderen Abtragevorgänge, eine chemische oder eine beliebig andere Abtrageeinheit verwendet werden. Im zweiten Materialabtragevorgang wird die Dicke der Halbleiterscheibe 1 auf die Zieldicke $d_2$ reduziert.

Da insbesondere bei chemischem Abtragen durch Rückätzen die Verfahrenskosten direkt von der Menge abzutragendem Material abhängen, ist es naheliegend und hat es sich bewährt, dass in einem ersten Materialabtragevorgang eine erhebliche Menge Material mechanisch abgetragen wird, bis auf die Ausgangsdicke $d_1$, und anschliessend in einem zweiten Materialabtragevorgang nur noch sehr wenig Material durch Ätzen entfernt wird, bis auf die genaue, gewünschte Zieldicke $d_2$.

Für die oben genannte Halbleiterscheibe beträgt die angestrebte Zieldicke $d_2$ je nach Grösse der Sperrspannung nur noch 60 -220 Mikrometer. Mit dem erfindungsgemässen Verfahren gelingt es, die Dicke der Halbleiterscheibe bereits mit dem ersten Materialabtragevorgang bis auf wenige 10 Mikrometer oder sogar ganz auf die gewünschte Zieldicke zu reduzieren.

Fig. 1 e) zeigt wiederum, wie das Gewicht $G_2$ der nun auf die Zieldicke $d_2$ reduzierten Halbleiterscheibe 1 festgestellt wird. Anhand des festgestellten Gewichts $G_2$ und der bekannten, oben aufgeführten Grössen wird in der Steuereinheit die genaue, mittlere Dicke $d_2$ der Halbleiterscheibe berechnet

$$d_2 = \frac{(G_2 - G_T)}{g} \cdot \frac{1}{A \cdot \rho_{Si}}.$$

Die so bestimmte Dicke $d_2$ kann zusammen mit der vorher bestimmten Ausgangsdicke $d_1$ für die Berechnung der Abtrageparameter für die Behandlung weiterer Halbleiterscheiben oder Gruppen von Halbleiterscheiben verwendet werden.

Fig. 1 f) zeigt schliesslich, wie die auf die Zieldicke $d_2$ verdünnte Halbleiterscheibe 1 am Schluss von der Folie 2 abgezogen wird. Wird im zweiten Materialabtragevorgang durch Ätzen Material abgetragen, ist in der Regel die Gefahr des Brechens gering, da allfällige mechanische Schäden durch das Ätzen beseitigt werden.

Wie eingangs bereits erwähnt muss insbesondere beim ersten, in der Regel mechanischen Materialabtragevorgang darauf geachtet werden, die Halbleiterscheibe nicht bricht.

Alternativ zum dargestellten Verfahren, könnte das Gewicht $G_0$ der Halbleiterscheibe 1 bereits vor dem ersten Materialabtragevorgang festgestellt werden. Damit könnte die ursprüngliche Dicke $d_0$ der Halbleiterscheibe ebenfalls bestimmt werden, und in die für den ersten Materialabtragevorgang relevanten Parameter einfliessen. Somit könnte bereits dieser erste Materialabtragevorgang mit der gewünschten Genauigkeit erfolgen. Insbesondere könnte möglicherweise auf diese Weise auf einen zweiten, oder weitere Materialabtragevorgänge verzichtet werden.

Die Halbleiterscheibe muss nicht zwingend während dem ganzen Verfahren auf der Folie aufliegen. Vielmehr kann die Halbleiterscheibe während dem Verfahren, insbesondere vor der ersten Gewichtsfeststellung oder vor dem zweiten Materialabtragevorgang, von der Folie abgezogen werden. Es kann auch gänzlich auf die Unterstützung von Folien verzichtet werden.

Hierfür ist es ganz besonders vorteilhaft, wenn das erfindungsgemässe Gerät zum Reduzieren der Dicke von Halbleiterscheiben derart ausgebildet ist, dass eine Halbleiterscheibe während dem gesamten Verfahren nicht bewegt werden muss.

Die unbehandelte Halbleiterscheibe wird direkt auf eine Auflage der Wägeeinheit gelegt und befestigt. Auf dieser Auflage befestigt wird die Halbleiterscheibe sowohl von der Wägeeinheit gewogen als auch von der Materialabtrageeinheit bearbeitet. Am Schluss des Verfahrens wird die auf die Zieldicke reduzierte Halbleiterscheibe von der Auflage entfernt.

Obwohl das erläuterte Ausführungsbeispiel im Wesentlichen auf Halbleiterscheiben zutrifft, ist es selbstverständlich, dass viele andere Arten von Scheiben (dünne Platten) auf diese Weise behandelt werden können.

Bezugszeichenliste

1    Dünne Scheibe, Halbleiterscheibe
2    Trägersubstrat
3    Materialabtrageeinheit
4    Wägeeinheit
$d_0$    Ursprüngliche Dicke der dünnen Scheibe
$d_1$    Ausgangsdicke der dünnen Scheibe (erste Dicke)
$d_2$    Zieldicke der dünnen Scheibe (zweite Dicke)

**Patentansprüche**

1.    Verfahren zum Reduzieren der Dicke von dünnen Scheiben, insbesondere von Halbleiterscheiben, bei welchem Verfahren für jede Scheibe (1) ein- oder mehrmalig folgende Verfahrensschritte durchgeführt werden:

- die Dicke ($d_0$, $d_1$, $d_2$) der Scheibe wird reduziert, indem von wenigstens einer Grundfläche der Scheibe Material abgetragen wird,

- vor und/ oder nach dem Abtragen von Material von der Scheibe (1) wird die Dicke ($d_0$, $d_1$, $d_2$) der Scheibe bestimmt,

- aufgrund der bestimmten Dicke ($d_0$, $d_1$, $d_2$) der Scheibe wird festgelegt, wieviel Material von der Scheibe (1) in einem folgenden Verfahrensschritt abgetragen werden soll, und/ oder wieviel Material von einer oder mehreren weiteren, dickemässig zu reduzierenden Scheiben abgetragen werden soll,

**dadurch gekennzeichnet, dass**

- zum Bestimmen der Dicke ($d_0$, $d_1$, $d_2$) der Scheibe das Gewicht der Scheibe festgestellt wird, und dass

- aufgrund des festgestellten Gewichts die Dicke ($d_0$, $d_1$, $d_2$) der Scheibe berechnet wird.

2.    Verfahren nach Anspruch 1, **dadurch gekennzeichnet, dass**

- in einem späteren Verfahrensschritt die Scheibe (1) von einem Trägersubstrat (2) getrennt wird, auf welches die Scheibe (1) in einem früheren Verfahrensschritt aufsetzt worden ist.

3.    Verfahren nach Anspruch 2, **dadurch gekennzeichnet, dass**

- wenigstens einmal während dem Bestimmen der Dicke ($d_1$, $d_2$) der Scheibe, insbesondere während dem Feststellen des Gewichts der Scheibe, die Scheibe (1) vom Trägersubstrat getragen wird.

4.    Verfahren nach einem der Ansprüche 2 bis 3, **dadurch gekennzeichnet, dass** folgende Verfahrensschritte der Reihe nach durchlaufen werden:

- die Scheibe (1) wird auf das Trägersubstrat (2) aufgesetzt,

- Material wird von wenigstens einer Grundfläche der Scheibe bis auf eine erste Dicke ($d_1$) der Scheibe abgetragen,

- die erste Dicke ($d_1$) der Scheibe wird durch Feststellen des Gewichts der Scheibe bestimmt,

- eine aufgrund der bestimmten, ersten Dicke ($d_1$) der Scheibe festgelegte Menge an Material wird von wenigstens einer Grundfläche der Scheibe bis auf eine zweite Dicke ($d_2$) der Scheibe abgetragen,

- die zweite Dicke ($d_2$) der Scheibe wird durch Feststellen des Gewichts der Scheibe bestimmt,

- Die Scheibe (1) wird vom Trägersubstrat (2) getrennt.

5. Verfahren nach einem der Ansprüche 2 bis 3, **dadurch gekennzeichnet, dass** folgende Verfahrensschritte der Reihe nach durchlaufen werden:

- Die Scheibe (1) wird auf das Trägersubstrat (2) aufgesetzt,

- Material wird von wenigstens einer Grundfläche der Scheibe bis auf eine erste Dicke ($d_1$) der Scheibe abgetragen,

- die Scheibe (1) wird vom Trägersubstrat (2) getrennt,

- die erste Dicke ($d_1$) der Scheibe wird durch Feststellen des Gewichts der Scheibe bestimmt,

- eine aufgrund der bestimmten, ersten Dicke ($d_1$) der Scheibe festgelegte Menge an Material wird von wenigstens einer Grundfläche der Scheibe (1) bis auf eine zweite Dicke ($d_2$) der Scheibe abgetragen,

- die zweite Dicke ($d_2$) der Scheibe wird durch Feststellen des Gewichts der Scheibe bestimmt.

6. Verfahren nach einem der Ansprüche 2 bis 3, **dadurch gekennzeichnet, dass** folgende Verfahrensschritte der Reihe nach durchlaufen werden:

- die Scheibe (1) wird auf das Trägersubstrat (2) aufgesetzt,

- Material wird von wenigstens einer Grundfläche der Scheibe bis auf eine erste Dicke ($d_1$) der Scheibe abgetragen,

- die erste Dicke ($d_1$) der Scheibe wird durch Feststellen des Gewichts der Scheibe bestimmt,

- die Scheibe (1) wird vom Trägersubstrat (2) getrennt,

- eine aufgrund der bestimmten, ersten Dicke ($d_1$) der Scheibe festgelegte Menge an Material wird von wenigstens einer Grundfläche der Scheibe bis auf eine zweite Dicke ($d_2$) der Scheibe abgetragen,

- die zweite Dicke ($d_2$) der Scheibe wird durch Feststellen des Gewichts der Scheibe bestimmt.

7. Verfahren nach einem der Ansprüche 2 bis 3, **dadurch gekennzeichnet, dass** folgende Verfahrensschritte der Reihe nach durchlaufen werden:

- die Scheibe (1) wird auf das Trägersubstrat (2) aufgesetzt,

- eine erste Dicke ($d_1$) der Scheibe wird durch Feststellen des Gewichts der Scheibe bestimmt,

- eine aufgrund der bestimmten, ersten Dicke ($d_1$) der Scheibe festgelegte Menge an Material wird von wenigstens einer Grundfläche der Scheibe bis auf eine zweite Dicke ($d_2$) der Scheibe abgetragen,

- die zweite Dicke ($d_2$) der Scheibe wird durch Feststellen des Gewichts der Scheibe bestimmt,

- die Scheibe (1) wird vom Trägersubstrat (2) getrennt.

8. Verfahren nach Anspruch 1, **dadurch gekennzeichnet, dass** folgende Verfahrensschritte der Reihe nach durchlaufen werden:

- eine erste Dicke ($d_1$) der Scheibe wird durch Feststellen des Gewichts der Scheibe (1) bestimmt,

- eine aufgrund der bestimmten, ersten Dicke ($d_1$) der Scheibe festgelegte Menge an Material wird von wenigstens einer Grundfläche der Scheibe bis auf eine zweite Dicke ($d_2$) der Scheibe abgetragen.

9. Verfahren nach Anspruch 8, **dadurch gekennzeichnet, dass**

- die zweite Dicke ($d_2$) der Scheibe wird anschliessend durch Feststellen des Gewichts der Scheibe bestimmt.

10. Verfahren nach einem der Ansprüche 4 bis 9, **dadurch gekennzeichnet, dass**

- das Abtragen des Materials mit Abtrageparameter gesteuert wird, und dass

- die bestimmte, erste ($d_1$) und/ oder die bestimmte, zweite Dicke ($d_2$) der Scheibe zur Berechnung dieser Abtrageparameter für weitere, dickemässig zu reduzierende Scheiben verwendet wird/werden.

**11.** Gerät zum Reduzieren der Dicke von dünnen Scheiben (1), insbesondere von Halbleiterscheiben, mit

- mindestens einer Materialabtrageeinheit (3) zum Abtragen von Material von den Scheiben (1),

- mindestens einer Messeinheit (4) zum Bestimmten der Dicke ($d_1$, $d_2$) der Scheiben, sowie

- einer mit der Materialabtrageeinheit (3) und der Messeinheit (4) verbundenen Steuereinheit,

**dadurch gekennzeichnet, dass**

- die Messeinheit eine Wägeeinheit (4) zum Feststellen des Gewichts der Scheiben umfasst.

**12.** Gerät nach Anspruch 11, **dadurch gekennzeichnet, dass**

- wenigstens eine Materialabtrageeinheit (3) sowie die Messeinheit (4) derart miteinander verbunden sind, dass sie eine gemeinsame Auflagefläche für die Scheiben (1) haben, damit sich die Scheiben (1) für das Materialabtragen und das Messen in derselben Lage befinden.

Fig.1

Fig.1

**Europäisches Patentamt**

## EUROPÄISCHER RECHERCHENBERICHT

Nummer der Anmeldung

EP 01 81 0351

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 788 871 A (HUH YUN JUN) 4. August 1998 (1998-08-04) * Zusammenfassung; Ansprüche 1,10,12; Abbildungen * * Spalte 1, Zeile 16 - Spalte 2, Zeile 28 * * Spalte 3, Zeile 26 - Zeile 37 * * Spalte 4, Zeile 58 - Spalte 5, letzte Zeile * | 1,2,8-12 | H01L21/66 B28D5/02 |
| Y | | 3-7 | |
| X | PATENT ABSTRACTS OF JAPAN vol. 013, no. 568 (E-861), 15. Dezember 1989 (1989-12-15) -& JP 01 236633 A (ROHM CO LTD), 21. September 1989 (1989-09-21) * Zusammenfassung * | 1,2,8-12 | |
| X | DE 196 41 070 A (WACKER SILTRONIC HALBLEITERMAT) 9. April 1998 (1998-04-09) * Zusammenfassung; Ansprüche * * Spalte 3, Zeile 10 - Zeile 17 * * Spalte 4, Zeile 45 - Zeile 62 * | 1,8-11 | RECHERCHIERTE SACHGEBIETE (Int.Cl.7) H01L B28D |
| Y | WO 00 00874 A (ADVANCED MICRO DEVICES INC) 6. Januar 2000 (2000-01-06) * Zusammenfassung; Abbildung 3 * * Seite 1, Absatz 2 - Seite 1, Absatz 1 * * Seite 4, Absatz 3 - Seite 6, Absatz 2 * | 3-7 | |
| A | EP 0 881 663 A (LINTEC CORP) 2. Dezember 1998 (1998-12-02) * Zusammenfassung; Abbildungen 6,8 * * Spalte 1, Zeile 15 - Spalte 2, Zeile 13 * * Spalte 6, Zeile 9 - Zeile 20 * | 2-7 | |

-/--

Der vorliegende Recherchenbericht wurde für alle Patentansprüche erstellt

| Recherchenort | Abschlußdatum der Recherche | Prüfer |
|---|---|---|
| BERLIN | 11. Oktober 2001 | Hamdani, F |

EPO FORM 1503 03.82 (P04C03)

**Europäisches Patentamt**

## EUROPÄISCHER RECHERCHENBERICHT

Nummer der Anmeldung

EP 01 81 0351

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 4 942 795 A (LINKE THOMAS A ET AL) 24. Juli 1990 (1990-07-24) * Spalte 1, Zeile 60 - Spalte 3, Zeile 40 * | 1,11 | |
| A | FR 2 285 210 A (CELESTRON PACIFIC) 16. April 1976 (1976-04-16) * Anspruch 1; Abbildungen * | 2 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| BERLIN | 11. Oktober 2001 | Hamdani, F |

## ANHANG ZUM EUROPÄISCHEN RECHERCHENBERICHT
### ÜBER DIE EUROPÄISCHE PATENTANMELDUNG NR.

EP 01 81 0351

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-10-2001

| Im Recherchenbericht angeführtes Patentdokument | | Datum der Veröffentlichung | Mitglied(er) der Patentfamilie | | Datum der Veröffentlichung |
|---|---|---|---|---|---|
| US 5788871 | A | 04-08-1998 | KR | 192489 B1 | 15-06-1999 |
| | | | JP | 2995542 B2 | 27-12-1999 |
| | | | JP | 9186130 A | 15-07-1997 |
| JP 01236633 | A | 21-09-1989 | KEINE | | |
| DE 19641070 | A | 09-04-1998 | DE | 19641070 A1 | 09-04-1998 |
| WO 0000874 | A | 06-01-2000 | US | 6230069 B1 | 08-05-2001 |
| | | | EP | 1090335 A1 | 11-04-2001 |
| | | | WO | 0000874 A1 | 06-01-2000 |
| EP 0881663 | A | 02-12-1998 | JP | 10330022 A | 15-12-1998 |
| | | | JP | 10329087 A | 15-12-1998 |
| | | | CN | 1208946 A | 24-02-1999 |
| | | | EP | 0881663 A2 | 02-12-1998 |
| | | | SG | 72813 A1 | 23-05-2000 |
| | | | TW | 385296 B | 21-03-2000 |
| | | | US | 6080263 A | 27-06-2000 |
| | | | US | 6258198 B1 | 10-07-2001 |
| US 4942795 | A | 24-07-1990 | DE | 3917223 A1 | 07-12-1989 |
| | | | JP | 2024018 A | 26-01-1990 |
| | | | JP | 2048110 C | 25-04-1996 |
| | | | JP | 7063885 B | 12-07-1995 |
| FR 2285210 | A | 16-04-1976 | FR | 2285210 A1 | 16-04-1976 |

EPO FORM P0461

Für nähere Einzelheiten zu diesem Anhang : siehe Amtsblatt des Europäischen Patentamts, Nr.12/82